# DEMANDE DE BREVET EUROPEEN

(11) **EP 1 954 108 A1**
(43) Date de publication de la demande: **06.08.2008**
(21) Numéro de dépôt: 08101161.1
(22) Date de dépôt: 31.01.2008
(51) Int. Cl.: H05K 1/02, H05K 3/34, H05K 1/16

(54) **Carte électronique incorporant une résistance chauffante**

(30) Priorité: 31.01.2007 FR 0700684
(71) Demandeur: HISPANO SUIZA, 92707 Colombes Cedex (FR)
(72) Inventeur: Glever, Bernard, 77370, NANGIS (FR); Goux, Daniel, 91470, LES MOLIERES (FR); Poirier, Robert, 95150, TAVERNY (FR)
(74) Mandataire: David, Daniel

(57) **Abrégé**

L'invention porte sur une carte électronique (1) comportant une zone (20) formant support de composant (10) électronique de type BGA, une résistance (25A) chauffante électrique au droit de ladite zone, ladite résistance étant susceptible de fournir une quantité de chaleur pour le brasage du composant sur la plaque, caractérisé par le fait que la carte comporte une pluralité de couches (21, 23, 25,...) conductrices en alternance avec des couches (22, 24, 26) isolantes électriquement, ladite résistance (25A) formant une des couches conductrices immédiatement sous jacentes de la couche de surface (21).

La carte comporte le cas échéant un drain thermique.

L'invention porte aussi sur une installation de mise en oeuvre du procédé. Elle permet aussi la réparation d'une carte électronique par remplacement des éléments défectueux sans risque de débraser ou d'endommager les éléments voisins.

## Description

La présente invention se rapporte au domaine des cartes électroniques et en particulier aux moyens permettant d'assurer le montage et le démontage de leurs composants par brasage.

Une carte électronique comprend globalement un support plan, appelé circuit imprimé qui est constitué d'un empilement de conducteurs appelés couches et séparées entres elles par des isolants électriques. Les composants électroniques sont montés sur ce support et les connexions électriques sont réalisées par des pattes métalliques qui sont brasées sur des plages de report sur le circuit imprimé. Le support est communément désigné dans le domaine par le sigle PCB (pour printed circuit board)

Les composants conventionnels, qui sont du type à sorties périphériques c'est à dire dont les pattes de connexion sont disposées à la périphérie du boîtier contenant la puce électronique, peuvent être aisément soudés au substrat. On peut apporter la chaleur nécessaire à la fusion de la brasure et au brasage en approchant la source de chaleur des pattes périphériques sans risquer d'endommager le composant par un chauffage excessif.

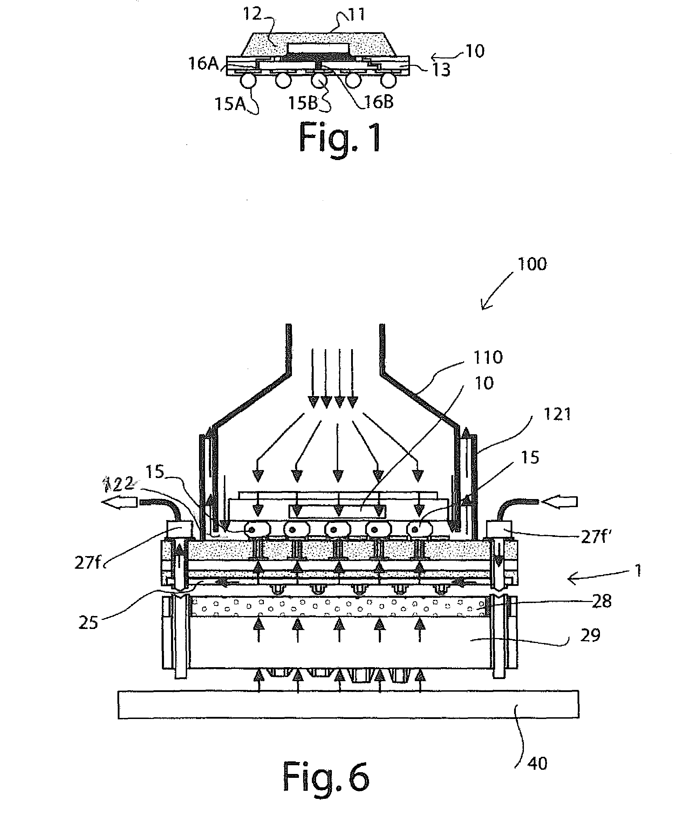

L'évolution technologique permet maintenant l'emploi de composants plus compacts, à sorties dites surfaciques. On a représenté sur la figure 1 un schéma d'un composant 10 de type désigné dans le domaine par BGA (pour ball grid array). Le composant comprend une puce électronique 11 noyée dans un matériau d'encapsulation 12, et sur le dessous un substrat 13. Des billes de report 15 sont solidaires du substrat sur l'autre côté et sont disposées en une grille. Une partie des billes 15A est reliée électriquement à la puce 11 par des moyens de connexion électriques 16A appropriés. Certaines billes 15B, localisées dans la partie centrale du substrat, sont reliées électriquement et thermiquement à la puce par des moyens de connexion 16B pour en drainer les calories du boîtier au PCB.

Par rapport aux composants à sorties périphériques, l'emploi de composants à sorties surfaciques présente cependant l'inconvénient de nécessiter leur chauffage pour en réaliser la brasure car les billes ne sont pas accessibles autrement. Pour braser ou débraser de tels composants, il est ainsi nécessaire de chauffer le boîtier à la température fusion de l'alliage de brasure, qui est par exemple de 195°C pour les alliages à base de plomb. On doit s'assurer que la température reste inférieure à celle de tenue de la puce qui est de 250°C.

En outre, dans certaines applications aéronautiques, les cartes électroniques sont enfermées dans des boîtiers dans lesquels ne circule aucun air de refroidissement. On insère alors dans le support, désigné PCB, une ou plusieurs feuilles métalliques appelées drains thermiques (généralement en cuivre) qui permettent de drainer la chaleur par conduction entre le ou les composants électroniques qui chauffent et l'extérieur du boîtier métalliques qui contient les cartes électroniques. Par ailleurs pour les applications aéronautiques en particulier, un vernis climatique recouvre l'ensemble de la carte, et la protège de l'humidité.

En raison du coût élevé des cartes électroniques dans certaines applications, notamment aéronautiques, il est important de pouvoir les réparer en remplaçant les composants défectueux. Le remplacement doit être effectué sans perturber les composants voisins. Une étape délicate consiste à apporter localement une quantité de chaleur suffisante pour entraîner la fusion de la brasure du seul composant à remplacer.

La présence des drains thermiques et du vernis climatique constitue dans ce contexte un inconvénient lorsqu'il s'agit de remplacer un composant type BGA c'est à dire de débraser et de le rebraser de son support

Les solutions courantes de l'art antérieur ne conviennent pas pour braser un nouveau composant ou débraser un composant existant lorsque le support comprend des drains thermiques. On est obligé dans ce cas d'apporter une quantité de chaleur plus importante pour tenir compte de son évacuation par le drain. Cet excès de chaleur est dommageable pour les composants voisins. Par ailleurs, le vernis climatique est susceptible de fondre lui aussi à la température de chauffage. Il risque de migrer dans les brasures voisines et d'altérer les connexions électriques.

La demanderesse a proposé dans la demande FR 2 864 419 Une solution. Ce procédé pour braser un composant électronique en réparation sur un support comportant au moins un drain thermique pour le dit composant, au moyen d'une pâte à braser incorporant un flux décapant activé à une première température, et un alliage de brasure fondant à une seconde température supérieure à la première, comprend les étapes consistant à :
- préchauffer le support par le drain thermique jusqu'à ladite première température,
- placer le composant sur le support avec la pâte à braser,
- chauffer le composant en appliquant un gaz chaud à une température suffisante pour activer le flux et amener l'alliage de la brasure à la seconde température.

Une pâte à braser utilisée dans ce type de procédé comprend communément, un alliage de brasure sous la forme en général de billes, un flux d'activation très léger pour le traitement des surfaces, et un diluant ou solvant. Par le chauffage à travers le drain thermique du support, on limite pendant le préchauffage l'apport de chaleur à celui nécessaire à l'activation du flux, la température du support et des composants voisins restant inférieure à celle de refusion de l'alliage de brasure de ces derniers. En outre, la chaleur nécessaire pour que l'alliage de brasure atteigne la température de fusion est apportée localement par la buse à gaz chaud au-dessus du composant. Le préchauffage de la carte est effectué par convection avec une plaque chauffante située sous la carte du côté opposé au composant concerné.

Le chauffage par air chaud du composant comprend une étape de préchauffage à une température intermédiaire, inférieure à la seconde température. On place la carte dans une enceinte au moins pendant l'étape de préchauffage, permettant d'homogénéiser les températures sur la carte. On applique le gaz chaud au moyen d'une buse disposée perpendiculairement au plan de la carte, associée à un moyen formant cheminée de retour des gaz après balayage du composant.

Dans la demande ci-dessus on a aussi décrit une installation d'assemblage et de réparation de cartes électroniques permettant la mise en oeuvre du ou des procédés précédents, comportant un moyen de fixation de ladite carte, un moyen pour le chauffage par conduction thermique sur un côté de la carte et un moyen constitué d'une plaque chauffante pour le chauffage par gaz chaud sur l'autre côté de ladite carte. Une telle installation permet à la fois la mise en oeuvre du procédé de brasage ci-dessus et d'assurer le débrasage d'un composant à remplacer sans affecter les composants voisins.

Le procédé convient tout à fait quand l'alliage utilisé est à base de plomb comme l'alliage étain plomb dont la température de fusion peut être ajustée à 195C°. Il n'est plus adapté au brasage mettant en oeuvre un alliage ne comprenant pas de plomb, se conformant aux directives sur l'environnement, et dont la température de fusion est plus élevée et qui est sensiblement plus proche de la température limite que peut supporter le composant. Ainsi un alliage tel que d'étain, cuivre et argent, répondant aux exigences règlementaires, a une température de fusion de 230 °C, 35°C supérieure à celle mentionnée plus haut, mais surtout proche de la limite des 250°C pour les composants

L'invention a donc pour objet de permettre l'emploi de brasures dont la température de fusion est supérieure à la température à laquelle on a brasé jusqu'à présent un composant de type BGA sur un circuit imprimé.

L'invention a également pour objet d'améliorer le procédé de l'art antérieur constituant l'objet de la demande de brevet sus mentionnée. Cette technique permet par ailleurs la réparation des cartes électroniques et le retrait du composant sans créer de contrainte thermique sur la carte, susceptible d'endommager une partie de la carte. Plus particulièrement, on peut localiser l'apport de chaleur nécessaire à la fusion de l'alliage de brasure du composant à retirer sans que l'on endommage les liaisons des composants voisins ou situés sous le support.

Conformément à l'invention, on parvient à ces objectifs avec une carte électronique comportant une zone formant support de composant électronique de type BGA, une résistance chauffante électrique au droit de ladite zone, ladite résistance étant susceptible de fournir une quantité de chaleur pour le brasage du composant sur la carte, caractérisée par le fait que ladite carte comporte en outre une pluralité de couches conductrices en alternance avec des couches isolantes électriquement, ladite résistance formant une des couches conductrices immédiatement sous jacentes de la couche de surface.

L'incorporation d'une résistance chauffante permet d'apporter la quantité de chaleur complémentaire nécessaire, le cas échéant, au brasage avec un matériau de température de fusion plus élevée que celle des alliages au plomb, dans le cas d'une carte avec drain thermique. On procède au brasage avec chauffage par air chaud d'un côté et apport de chaleur par une plaque chauffante de l'autre. La résistance additionnelle permet de circonscrire l'apport de chaleur à la brasure sans affecter les composants électroniques. Bien que l'intérêt de la solution se perçoive d'abord pour une carte avec drain thermique, l'ajout d'une résistance chauffante convient également au cas d'une carte ne comportant pas de drain thermique.

Il est à noter également que la résistance additionnelle, ici n'est pas à confondre avec les résistances chauffantes que sont susceptibles de comporter les cartes électroniques utilisées en aéronautique et dont la fonction est d'apporter une quantité de chaleur suffisante à l'ensemble de la carte pour en permettre un fonctionnement satisfaisant aux températures très basses.

Conformément à une autre caractéristique ladite zone formant support de composant électronique comprend une pluralité de pastilles sur lesquels le composant est brasé, la résistance chauffante formant des zones de chauffage disposées sous les dits pastilles, de préférence directement sous celles-ci.

La carte de l'invention présente un intérêt particulier dans le cadre du procédé de brasage/débrasage d'un composant électronique de type BGA ou tous types de composant dont les brasures de connexion sont inaccessibles comprenant un premier chauffage de la brasure depuis la face opposée de la carte par rapport au composant, la dite résistance chauffante constituant un apport complémentaire de chaleur pour élever la température de la brasure, notamment jusqu'à la température de fusion.

Plus particulièrement, ledit chauffage de la brasure depuis la face opposée est obtenu par conduction au moyen d'une plaque chauffante.

Conformément à une autre caractéristique, le procédé comprend la mise en oeuvre d'un deuxième chauffage au moyen d'un gaz chaud appliqué sur le composant.

L'invention va maintenant être décrite plus en détail en référence aux dessins annexés sur lesquels,
- la figure 1 représente en coupe transversale le schéma d'un composant à sorties surfaciques,
- la figure 2 représente en coupe transversale selon la ligne 2-2 de la figure 3, une partie de carte électronique équipée d'un composant lié par brasage, et avec drains thermiques dans le support,
- la figure 3 représente schématiquement une coupe selon la direction 3-3, de la figure 2,
- la figure 4 représente schématiquement une coupe selon la direction 4-4 de la figure 2,
- la figure 5 représente schématiquement une coupe selon la direction 5-5 de la figure 2,
- la figure 6 représente une installation permettant le brasage d'un composant électronique de type BGA sur une carte à circuit imprimé selon l'invention.

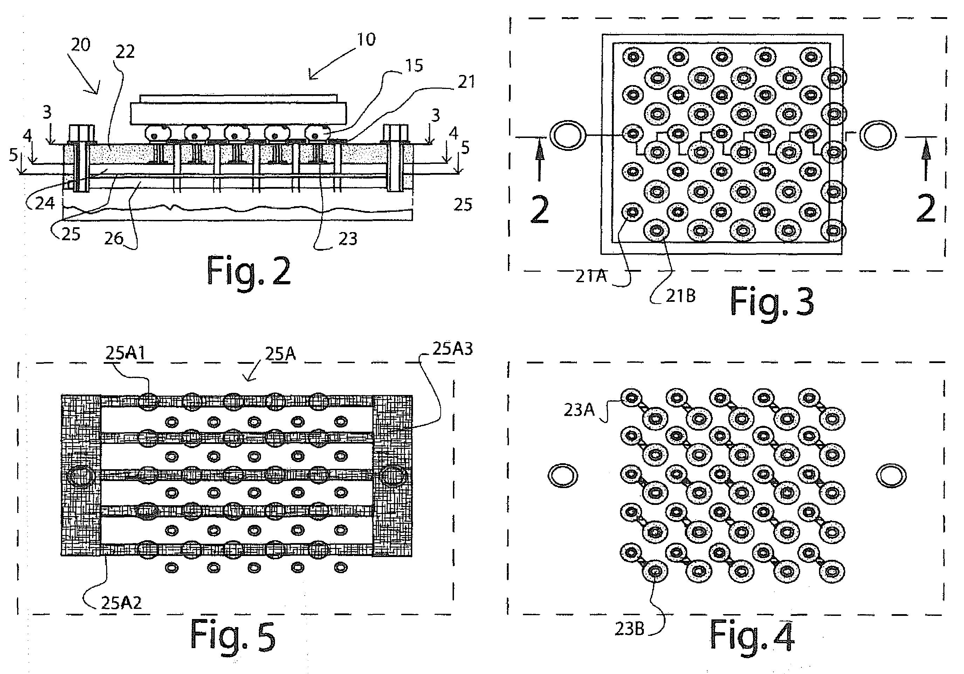

A la figure 2 on a représenté partiellement une carte électronique incorporant le moyen de l'invention dans la zone de montage du composant électronique BGA. La carte 20 comprend une pluralité de couches électroniques 21, 23, 25... conductrices interposées entre des couches isolantes électriquement 22, 24, 26. Seules les trois premières de chaque sont illustrées ici mais la carte en comporte généralement un nombre plus important. La première couche, 21, que l'on voit aussi sur la figure 3, comprend des pastilles 21A formant les contacts électriques avec le composant par l'intermédiaire des billes 15 de brasure. Les pastilles 21A sont en contact électrique avec les contacts 23A de la couche électronique sous-jacente 23 que l'on voit sur la figure 4. La première couche comprend également des pastilles 21B et la couche 23 des contacts 23B. Ces pastilles sont reliées entre elles par des trous métallisés qui permettent de réaliser les interconnexions électriques de tous les composants câblés sur les surfaces externes de la carte électronique de manière à assurer la fonctionnalité électrique de la carte

La couche sous-jacente 25 comprend une résistance électrique chauffante 25A, conformément à l'invention. On voit sur la figure 5 le détail de la géométrie de cette résistance électrique. Elle a la forme d'une grille avec des surfaces de chauffe 25A1 reliées par des brins 25A2, eux-mêmes reliés à deux brins latéraux 25A3. Les deux brins latéraux 25A3 sont reliés électriquement chacun à un trou métallisé 27 et 27'respectivement qui traverse la carte perpendiculairement à son plan. Les trous métallisés 27 et 27' ont pour fonction d'assurer le branchement de la résistance à une source électrique extérieure.

On observe que les surfaces de chauffe sont disposées au droit des pastilles 21A formant contacts sur la première couche 21.

En se reportant à la figure 6, on voit une installation 100 d'assemblage et de réparation de cartes électroniques permettant le brasage ou le débrasage de composants électroniques de type BGA, dans laquelle on a placé une carte électronique 1, avec sa zone support 20 sur laquelle est disposé le composant 10.

Par rapport à la figure 2, on a représenté la couche formant drain thermique 28 et la plaque de base 29. La carte comprend encore une succession de couches non représentées entre la couche 25 comprenant la résistance chauffante et la couche métallique formant drain thermique 28.

L'installation comprend une plaque chauffante 40 sur laquelle la carte est posée. Des fiches 27f et 27f' sont logées dans les trous métallisés 27 et 27'. Les fiches sont reliées à une source d'énergie électrique.

Le moyen de chauffage de la plaque 40 n'est pas représenté. Il peut être électrique par exemple. Sur le dessus de la carte on a disposé une buse 110 perpendiculairement au plan du support. La largeur de la buse 110 est suffisante pour couvrir le composant 10. Sur la figure sont représentés deux éléments de paroi 121 extérieurs aux parois de la buse et parallèles à son axe en ménageant un passage. Ils constituent une cheminée de retour des gaz. On a indiqué par des flèches la direction du gaz incident guidé par les parois de la buse et du même gaz après son impact contre le composant.

Avantageusement, on enveloppe l'ensemble de la carte et de la plaque chauffante dans une enceinte de protection thermique ici non représentée dans le but de parvenir à bonne homogénéité en température des différents éléments qui la composent. Avantageusement, la buse comporte des ouvertures 122 ménagées aux endroits où se situent les composants à braser ou à débraser, selon qu'il s'agit d'assembler une carte ou bien de la réparer en en changeant un composant. Ces ouvertures sont obstruées par exemples aux endroits où l'on n'a pas à intervenir. Les éléments de paroi 121 sont par exemple placés le long des bords de l'ouverture 122 de manière à former une barrière aux gaz lorsqu'on place une buse de chauffage par l'ouverture. Les parois forment une cheminée avec les parois d'une buse que l'on place dans l'ouverture.

On décrit un exemple de cycle de brasage d'un composant spécifique.

On procède au préchauffage de la carte au moyen de la plaque chauffante 40 ; la chaleur produite par la plaque est transmise jusqu'aux éléments métalliques formant les drains thermiques de la carte. La montée en température est continue jusqu'à ce que la carte atteigne une température définie.

On met ensuite en place le composant sur le support en interposant la pâte à braser. La température est suffisante pour activer le flux de décapage contenu dans la crème à braser.

On insuffle de l'air chaud par la buse sur le composant à une température de 250°C à 300°C. L'air balaie la surface supérieure du composant contourne le bord libre de la buse et est guidé par les parois de la cheminée en étant dévié à 180° par rapport à la direction initiale. La température au niveau des billes du composant atteint ainsi progressivement 165°C-170°C.

On augmente alors la température de l'air chaud jusqu'à 400-490°C.
On apporte une quantité de chaleur complémentaire en alimentant la résistance chauffante 25A pendant une durée déterminée, suffisamment courte pour ne pas endommager les composants voisins et celui à braser. Dans la mesure où les surfaces de chauffe sont localisées au droit des pastilles à braser on réduit encore le risque d'affecter les autres composants ; la température sur les billes monte progressivement jusqu'à 230°C et celle de la puce à 230-240°C. La température de fusion de l'alliage constituant la brasure est atteinte. On arrête le flux d'air chaud.

Lors de la réparation d'une carte électronique, on procède selon un cycle similaire ou, préférentiellement dans un but de simplification des modes opératoires, selon le même cycle que celui qui a été établi pour le brasage du composant concerné. En particulier on préchauffe la carte jusqu'à la première température afin que les contraintes crées dans la carte soient équilibrées.

Dans le second cas la température de préchauffage atteint sans difficulté la température d'activation des flux. Cependant on réduit sensiblement la dispersion des températures dans les différents points sur la carte quand on enferme la carte dans une enceinte de protection thermique.

## Revendications

1. Carte électronique (1) comportant une zone (20) formant support de composant (10) électronique de type BGA, une résistance (25A) chauffante électrique au droit de ladite zone, ladite résistance étant susceptible de fournir une quantité de chaleur pour le brasage du composant sur la plaque, **caractérisé par le fait que** la carte comporte une pluralité de couches (21, 23, 25,...) conductrices en alternance avec des couches (22, 24, 26) isolantes électriquement, ladite résistance (25A) formant une des couches conductrices immédiatement sous jacentes de la couche de surface (21).

2. Carte selon la revendication précédente dont ladite zone (20) formant support de composant électronique (10) comprend une pluralité de pastilles (21A) sur lesquelles le composant est brasé, la résistance chauffante comportant des surfaces de chauffe (25A1) disposées sous les dites pastilles.

3. Carte selon l'une des revendications précédentes dont la résistance chauffante comporte des moyens (27, 27') formant contacts pour le branchement d'une alimentation électrique extérieure.

4. Carte selon l'une des revendications précédentes comportant un drain thermique (28).

5. Procédé de brasage/débrasage d'un composant électronique de type BGA sur une carte électronique à circuit imprimé selon l'une des revendications précédentes comprenant un premier chauffage de la brasure depuis la face opposée de la carte par rapport au composant, la dite résistance chauffante constituant un apport complémentaire de chaleur pour élever la température de la brasure jusqu'à la température de fusion.

6. Procédé selon la revendication 5 selon lequel ledit chauffage de la brasure depuis la face opposée est obtenu par conduction au moyen d'une plaque chauffante.

7. Procédé selon la revendication précédente comprenant un deuxième chauffage au moyen d'un gaz chaud appliqué sur le composant.

8. Procédé selon la revendication précédente selon lequel on guide le gaz chaud au moyen d'une cloche comportant des moyens d'évacuation du gaz après qu'il a balayé ledit composant.
